(19) Europäisches Patentamt
European Patent Office
Office européen des brevets

(11) **EP 2 685 492 B1**

## (12) EUROPÄISCHE PATENTSCHRIFT

(45) Veröffentlichungstag und Bekanntmachung des Hinweises auf die Patenterteilung:
**11.07.2018 Patentblatt 2018/28**

(51) Int Cl.:
*H01L 23/373* (2006.01)          *H01L 23/498* (2006.01)

(21) Anmeldenummer: **13168160.3**

(22) Anmeldetag: **17.05.2013**

(54) **Leistungshalbleitermodul mit mindestens einem stressreduzierenden Anpasselement**

Power semiconductor module with at least one stress-reducing adjustment element

Module semi-conducteur de puissance comprenant au moins un élément d'ajustement réduisant les contraintes

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **09.07.2012 DE 102012211952**

(43) Veröffentlichungstag der Anmeldung:
**15.01.2014 Patentblatt 2014/03**

(73) Patentinhaber: **SEMIKRON Elektronik GmbH & Co. KG**
**90431 Nürnberg (DE)**

(72) Erfinder:
• **Augustin, Karlheinz**
 **90768 Fürth (DE)**

• **Faltenbacher, Josef**
 **91052 Erlangen (DE)**
• **Sagebaum, Ulrich**
 **90537 Feucht (DE)**
• **Windischmann, Jürgen**
 **96178 Pommersfelden (DE)**
• **Beckedahl, Peter**
 **90522 Oberasbach (DE)**

(56) Entgegenhaltungen:
EP-A2- 0 706 221          EP-A2- 1 548 829
DE-A1- 4 300 516          DE-A1- 19 647 590
DE-A1-102006 009 021      DE-A1-102007 034 491
DE-A1-102010 044 709      JP-A- H09 321 216
JP-A- S62 202 544         JP-A- 2001 284 525

EP 2 685 492 B1

**Beschreibung**

Die Erfindung beschreibt ein Leistungshalbleitermodul mit einem isolierenden Substrat, hierauf angeordneten Leiterbahnen, dort angeordneten Leistungshalbleiterbauelementen und Anschlusselementen zur äußeren elektrischen Verbindung.

Gemäß dem allgemein bekannten Stand der Technik sind die Anschlusselemente derartiger Leistungshalbleitermodule aus einem elektrisch gut leitenden Metall, beispielhaft Kupfer oder hoch kupferhaltigen Legierungen, ausgebildet. Bekannte Substrate weisen einen Isolierstoffkörper aus einem keramischen Material, wie Aluminiumoxid, Aluminiumnitrid oder Siliziumnitrid auf. Auf diesem Isolierstoffkörper sind fachüblich Leiterbahnen, meist aus Kupfer, angeordnet. Das Substrat also der Verbund aus Isolierstoffkörper und Leiterbahnen weist damit einen Ausdehnungskoeffizienten auf der typisch im Bereich von $2 \cdot 10^{-6} \, K^{-1}$ liegt, während die Anschlusselemente einen typischen Ausdehnungskoeffizient von $16 \cdot 10^{-6} \, K^{-1}$ aufweisen. Ein gattungsgemäßes Leistungshalbleitermodul ist beispielhaft aus der DE 10 2009 037 257 A1 bekannt. Auch EP0706221 offenbart ein Leistungshalbleitermodul nach dem Stand der Technik. Die elektrisch leitende Verbindung des Anschlusselements mit einer Leiterbahn ist fachüblich häufig als stoffschlüssige Verbindung ausgebildet. Im Dauerbetrieb von Leistungshalbleitermodulen wirken auf diese Verbindung Kräfte, die von den unterschiedlichen Ausdehnungskoeffizienten der beteiligten Komponenten bestimmt werden. Es zeigt sich, dass die stoffschlüssige Verbindung des Anschlusselements und der Leiterplatte häufig sehr stabil ist. Demgegenüber ist die Verbindung der Substratkomponenten, also der Leiterbahn und des Isolierstoffkörpers häufig weniger belastbar, was zu einer meist lokal begrenzten Ablösung der Leiterbahn, samt daran anhaftendem Anschlusselement von dem Isolierstoffkörper führt.

Ein vergleichbarer Effekt kann bereits bei der Herstellung der stoffschlüssigen Verbindung des Anschlusselements und der Leiterplatte auftreten, beispielhaft bei Schweißvorgängen, die die Verbindung zwischen dem zugeordneten Leiterbahnabschnitt und dem Isolierstoffkörper lokal zerstören.

In Kenntnis dieser Gegebenheiten liegt der Erfindung die Aufgabe zugrunde, ein Leistungshalbleitermodul der oben genannten Art derart weiter zu bilden, dass ein Ablösen der Leiterbahn vom Isolierstoffkörper unter Dauerbelastung vermieden wird.

Diese Aufgabe wird erfindungsgemäß gelöst durch ein Leistungshalbleitermodul mit den Merkmalen des Anspruchs 1. Bevorzugte Ausführungsformen sind in den jeweiligen abhängigen Ansprüchen beschrieben.

Die Erfindung geht aus von einem Leistungshalbleitermodul mit einem Substrat zur Anordnung auf einer Kühleinrichtung oder einer Grundplatte. Es sind somit beide grundsätzlich bekannten Arten von Leistungshalbleitermodulen hierunter subsummiert. Einerseits die fachübliche Ausgestaltung mit einer wärmeverteilenden Grundplatte als Teil des Leistungshalbleitermoduls an sich, wobei diese Grundplatte dazu dient das Leistungshalbleitermodul auf einer nicht zum Leistungshalbleitermodul gehörigen Kühleinrichtung zu befestigen. Andererseits die modernere Variante von Leistungshalbleitermodulen ohne eine derartige Grundplatte. Bei dieser Ausgestaltung wird das Leistungshalbleitermodul direkt mit seinem Substrat auf einer nicht zum Leistungshalbleitermodul gehörigen Kühleinrichtung befestigt.

Das Substrat des erfindungsgemäßen Leistungshalbleitermoduls weist einen Isolierstoffkörper mit einer ersten metallischen Schicht auf, die auf dessen ersten, dem Inneren des Leistungshalbleitermoduls zugewandten, Hauptfläche angeordneten ist und mit einer zweiten metallischen Schicht, die auf der zweiten, dem Inneren des Leistungshalbleitermoduls abgewandten, Hauptfläche angeordneten ist.

Die erste metallische Schicht ist in sich strukturiert und bildet somit erste Leiterbahnen des Substrats aus. Auf einer ersten Leiterbahn ist ein Leistungshalbleiterbauelement angeordnet und elektrisch leitend damit verbunden. Weiterhin sind auf dieser oder einer weiteren ersten Leiterbahn des Substrats ein erstes Anpasselement und hierauf ein Anschlusselement angeordnet. Hierbei ist eine erste dem Anschlusselement zugewandte Hauptfläche des ersten Anpasselements stoffschlüssig und elektrisch leitendend mit diesem verbunden.

Diese stoffschlüssige Verbindung bildet eine erste Verbindungsart aus, die grundsätzlich fachspezifisch ausgebildet ist.

Eine zweite der Leiterbahn zugewandte Hauptfläche des ersten Anpasselements ist hierbei mittels eines Verbindungsmittels elektrisch leitend und stoffschlüssig hiermit verbunden, wodurch eine zweite Verbindungsart, die explizit ein hierzu notwendiges Verbindungsmittel voraussetzt, ausgebildet wird. Diese zweite Verbindungsart bildet somit eine Teilgruppe der ersten Verbindungsart.

Der Vorteil eines Leistungshalbleitermoduls mit erstem Anpasselement liegt insbesondere darin, dass wechselnde thermische Belastungen im Dauerbetrieb nicht nur eine einzige Verbindung zwischen einem Anschlusselement und einer Leiterbahn aufweisen und somit diese alle Belastungen aufnehmen muss. Vielmehr wird die Belastung auf zwei Verbindungen verteilt.

Die Folgenden sich nicht selbstverständlich ausschließenden fakultativen Merkmale können alleine oder in beliebigen Kombinationen in dem erfindungsgemäßen Leistungshalbleitermodul verwirklicht sein.

In einer besonders bevorzugten Ausgestaltung weist das Leistungshalbleitermodul ein zweites Anpasselement auf, das zu einer Kühleinrichtung oder einer Grundplatte angeordnet ist. Hierbei ist eine erste der zweiten metallischen Schicht zugewandte Hauptfläche des zweiten Anpasselements mittels eines Verbindungsmittels stoffschlüssig verbunden, wobei diese Verbindung wiederum der zweiten Verbindungsart entspricht.

Eine zweite der Kühleinrichtung oder der Grundplatte zugewandte Hauptfläche des Anpasselements ist stoffschlüssig hiermit verbunden, wobei diese Verbindung der ersten Verbindungsart entspricht, die nicht notwendigerweise ein Verbindungsmittel voraussetzt.

Verbindungen der ersten Verbindungsart sind insbesondere diejenigen die ein explizites Verbindungsmittel benötigen, also Löt- und Drucksinterverbindungen wie auch diejenigen die ohne ein derartiges Verbindungsmittel auskommen, also Schweiß-, insbesondere Reibschweißverbindungen oder Plattier-, insbesondere Walzplattierverbindungen. Die zweite Verbindungsart ist immer dadurch charakterisiert, dass ein explizites Verbindungsmittel benötigt wird, sie also insbesondere als Löt- oder Drucksinterverbindung ausgebildet ist.

Besonders vorteilhaft ist es, wenn das erste Anpasselement einen Wärmeausdehnungskoeffizienten aufweist der um plus/minus maximal 30% des Unterschiedes der Wärmeausdehnungskoeffizienten des Substrats und des Anschlusselements um den Mittelwert dieser Wärmeausdehnungskoeffizienten abweicht. Bei den oben genannten Werten für diese Wärmeausdehnungskoeffizienten eines Anschlusswinkels ($\alpha_A$) und eines Substrats ($\alpha_S$), weist das Anpasselement ($\alpha_X$) gemäß folgender Formel

$$\alpha_X = \tfrac{1}{2} \cdot (\alpha_A + \alpha_S) \pm 0{,}3 \cdot |\alpha_A - \alpha_S|$$

bevorzugt einen Wärmeausdehnungskoeffizienten auf, der $9 \pm 4{\cdot}10^{-6}$ K$^{-1}$ beträgt. Beispielhaft eignet sich bei oben genannten Werten Molybdän besonders gut. Ebenso vorteilhaft kein ein Verbundmaterial aus zwei oder drei Schichten vorteilhaft sein.

Bei Vorliegen eines zweiten Anpasselements ist eine analoge Ausprägung vorteilhaft. Hierbei weist das zweite Anpasselement einen Wärmeausdehnungskoeffizienten auf der um plus/minus maximal 30% des Unterschiedes der Wärmeausdehnungskoeffizienten des Substrats und der Kühleinrichtung bzw. der Grundplatte um den Mittelwert dieser Wärmeausdehnungskoeffizienten abweicht. Bei dem oben genannten Wert des Wärmeausdehnungskoeffizienten des Substrats und einem Wärmeausdehnungskoeffizienten von $23{\cdot}10^{-6}$ K$^{-1}$ der einer Kühleinrichtung, die beispielhaft aus Aluminium besteht, weist das Anpasselement vorzugsweise einen Wärmeausdehnungskoeffizienten auf der $13{,}5 \pm 10{\cdot}10^{-6}$ K$^{-1}$ beträgt. Beispielhaft eignet sich hiermit Kupfer, auch im Hinblick auf die übrigen Eigenschaften, wie thermische Leitfähigkeit, besonders gut.

Bei der Auswahl des Werkstoffes für das jeweilige Anpasselement gemäß den beiden oben genannten Wertebereichen kann deren Dicke relativ gering bemessen werden. Beispielhaft bei einer Leiterbahndicke von $300\mu$m kann das erste Anpasselement in diesem Dickenbereich und speziell auch dünner, insbesondere bis zur halben Leiterbahndicke, gewählt werden.

Im Rahmen dieser Ausgestaltung wird das durch Belastung, insbesondere während der Herstellung oder durch thermische Dauerbelastung im Betrieb, verursachte Ablösen einer Leiterbahn vom dem Isolierstoffkörper durch die mittelbar und nicht direkt ausgebildete Verbindung besonders wirksam verhindert.

Falls die Werkstoffe des jeweiligen Anpasselements nicht den oben genannten Bedingungen gehorchen, kann eine vergleichbare Wirkung erzielt werden, wenn das jeweilige Anpasselement eine Dicke aufweist, die mindestens das Dreifache der Dicke der zugeordneten metallischen Schicht des Substrats entspricht. Beispielhaft bedeutet dies bei einer Leiterbahndicke von $300\mu$m eine Mindestdicke des ersten Anpasselements von $900\mu$m. Bei dieser Ausgestaltung kann das durch die thermische Ausdehnung bedingte Ablösen der Leiterbahn von dem Isolierstoffkörper ebenso effektiv verhindert werden.

Vorzugsweise weist jedes Anschlusselement ein eigenes zugeordnetes erstes Anpasselement auf. Hierbei sollte dieses erste Anpasselement eine jeweilige laterale Ausdehnung aufweisen, die maximal das Eineinhalbfache der lateralen Ausdehnung der Kontaktfläche zum Anschlusselemente beträgt. Dies ist insbesondere vorteilhaft, wenn das erste Anpasselement in unmittelbarer Nähe zu einem Rand- oder einem Eckbereich einer zugeordneten Leiterbahn angeordnet ist.

Es kann alternativ aber ebenso bevorzugt sein, wenn das erste Anpasselement selbst als interne Verbindungseinrichtung zwischen dem Anschlusselement und einer ersten dem Substrat abgewandten Kontaktfläche eines Leistungshalbleiterbauelements weitergebildet ist.

Für ein zweites Anpasselement ist es besonders vorteilhaft, wenn es eine laterale Ausdehnung aufweist die größer ist als die Ausdehnung der zugeordneten zweiten metallischen Schicht des Substrats. Dies gilt insbesondere, wenn das zweite Anpasselement integraler Bestandteil einer Kühleinrichtung ist.

Weitere Erläuterung der Erfindung vorteilhafte Einzelheiten und Merkmale ergeben sich aus der nachfolgenden Beschreibung der in den Fig. 1 bis 4 dargestellten Ausführungsbeispiele der erfindungsgemäßen Anordnung oder von Teilen hiervon.

Figur 1 zeigt einen Ausschnitt einer ersten Ausführungsform eines erfindungsgemäßen Leistungshalbleitermoduls in Seitenansicht.

Figur 2 zeigt einen Ausschnitt einer zweiten Ausführungsform eines erfindungsgemäßen Leistungshalbleitermoduls in Seitenansicht.

Figur 3 zeigt einen Ausschnitt einer dritten Ausführungsform eines erfindungsgemäßen Leistungshalbleitermoduls in Seitenansicht.

Figur 4 zeigt einen Ausschnitt einer vierten Ausführungsform eines erfindungsgemäßen Leistungshalbleitermoduls in Draufsicht.

Figur 5 zeigt ein erfindungsgemäßes Leistungshalbleitermodul in dreidimensionaler Explosionsdarstellung.

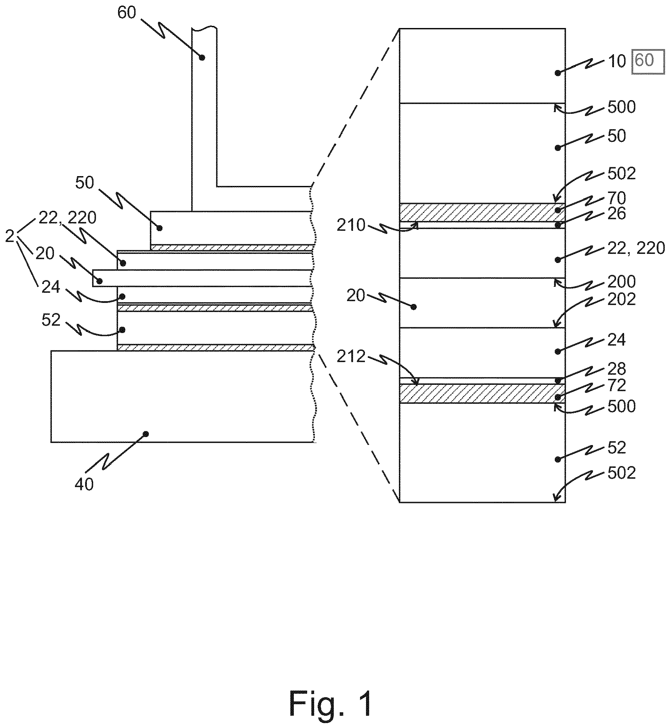

Figur 1 zeigt einen Ausschnitt einer ersten Ausführungsform eines erfindungsgemäßen Leistungshalbleitermoduls in Seitenansicht. Dargestellt ist zudem eine Ausschnittsvergrößerung eines Teiles hiervon zur Verdeutlichung der konstruktiven Ausgestaltung.

Zentraler Bestandteil des Leistungshalbleitermoduls ist das Substrat 2, hier bestehend aus einem Isolierstoffkörper 20 ausgebildet als eine Industriekeramik, eine Aluminiumoxidkeramik mit einer Dicke zwischen $100\mu m$ und $700\mu m$, mit zwei metallischen Schichten 22, 24 auf den jeweiligen Hauptflächen 200, 202 des Isolierstoffkörpers 20. Auf der ersten dem Inneren des Leistungshalbleitermoduls zugewandten Hauptfläche 200 des Isolierstoffkörpers 20 ist die erste metallische Schicht 22 angeordnet, die ihrerseits in sich strukturiert ist und somit elektrisch voneinander isolierte Leiterbahnen 220, 222 ausbildet, von denen nur eine dargestellt ist.

Auf der zweiten Hauptfläche 202 des Isolierstoffkörpers 20 ist die zweite metallische Schicht 24 flächig angeordnet, Es kann grundsätzlich auch vorteilhaft sein, wenn die zweite metallische Schicht 24 spiegelsymmetrisch zur ersten ausgebildet ist, wenn also den Leiterbahnen 220, 222 in der Projektion deckungsgleiche Bereiche gegenüberliegen. Beide metallische Schichten 22, 24 bestehen vorzugsweise aus Kupfer mit einer Dicke zwischen $100\mu m$ und $500\mu m$ und weisen an ihrer jeweiligen frei liegenden Seite eine bevorzugte aber nicht für alle Verbindungsarten notwendige Edelmetallschicht 26, 28 auf, die nur wenige Atomlagen bis zu $5\mu m$ dick ist und im weiteren als Bestandteil der jeweiligen metallischen Schicht 22, 24 angesehen wird. Ein derartiges Substrat 2 weist durch den Materialmix aus dem keramischen Isolierstoffkörper 20 und den metallischen Schichten 22, 24 einen Wärmeausdehnungskoeffizient auf der etwa bei $2\cdot 10^{-6}$ $K^{-1}$ liegt.

Auf der dem Inneren des Leistungshalbleitermoduls zugewandten ersten Hauptfläche 210 des Substrats 2 ist mittels einer zweiten Verbindungsart ein erstes Anpasselement 50 mit seiner zweiten Hauptfläche 502 angeordnet und elektrisch leitend mit der Leiterbahn 220 verbunden. Diese Verbindung muss gemäß der Erfindung mittels eines Verbindungsmittels 70, also als zweite Verbindungsart, ausgebildet sein, da mittels dieser zweiten Verbindungsart ausgebildete Verbindungen die Anhaftung der metallischer Schichten 22, 24 auf dem Isolierstoffkörper 20 weniger belasten als stoffschlüssige Verbindungsverfahren, insbesondere Schweißverbindungsverfahren, ohne Verbindungsmittel. Insbesondere ist dies für Substrate 2 die mittels des DCB-Verfahrens hergestellt sind vorteilhaft.

Bei einer Sinterverbindung zwischen der Leiterbahn 22 und dem ersten Anpasselement 50 ist es zudem vorteilhaft die beiden korrespondierenden Kontaktflächen mit einer Edelmetallschicht zu versehen. Diese ist hier nur für die Leiterbahn 22 dargestellt, aber in analoger Weise auch am ersten Anpasselement 50 vorzusehen.

Dieses erste Anpasselement 50 ist bevorzugt aus Kupfer ausgebildet, weil Kupfer eine sehr gute thermische Leitfähigkeit aufweist. Da das Anschlusselement 60 ebenfalls aus Kupfer ausgebildet ist, ist es vorteilhaft die Dicke des ersten Anpasselements 60 mindestens gemäß dem Dreifachen der Dicke der zugeordneten Leiterbahn 22 zu wählen.

Auf der ersten Hauptfläche 500 des ersten Anpasselements 50 ist das Anschlusselement 60 mit seiner korrespondierenden Kontaktfläche angeordnet und stoffschlüssig elektrisch leitend verbunden. Diese stoffschlüssige Verbindung kann beliebig als erste Verbindungsart, insbesondere auch als Schweißverbindung, ausgebildet sein. Die Schweißverbindung ist dadurch gekennzeichnet, dass kein Verbindungsmittel zwischen den Verbindungspartner angeordnet ist. Das Anschlusselement 60 kann ohne Beeinträchtigung oben genannter Funktion auch eine Galvanisierung der Oberfläche, beispielhaft aus Nickel aufweisen. Falls die stoffschlüssige Verbindung zwischen dem Anschlusselement 60 und dem ersten Anpasselement 50 eine Sinterverbindung ist, ist es gleichfalls vorteilhaft zumindest die korrespondierenden Kontaktflächen mit einer nicht dargestellten Edelmetalloberfläche auszubilden.

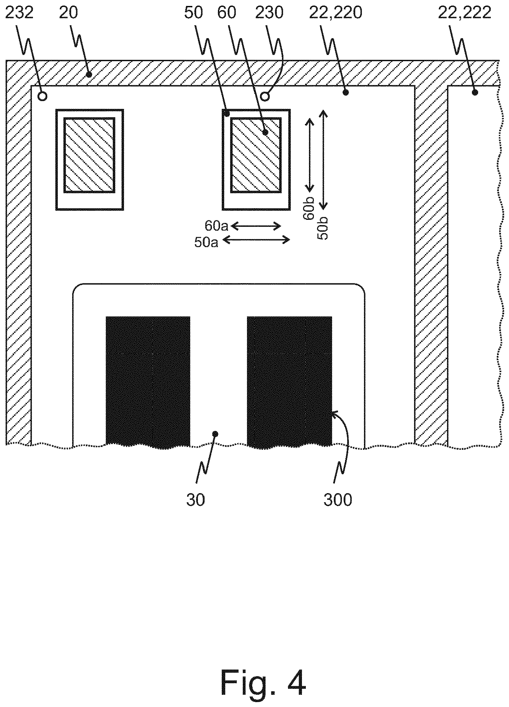

Bei der Ausgestaltung gemäß Fig. 1 ist das erste Anschlusselement 60 im Randbereich, vgl. auch Fig. 4, der Leiterbahn 220 des Substrats 2 angeordnet. Weiterhin ist bei dieser Ausgestaltung, vgl. ebenfalls Fig. 4, die laterale Ausdehnung des ersten Anpasselements 50 nur geringfügig größer als die Ausdehnung des Kontaktbereichs des Anschlusselements 60.

In vorteilhafter Weise weist die zweite metallische Fläche 24 ein auf ihr bündig angeordnetes zweites Anpasselement 52 auf. Dieses ist mittels einer zweiten Verbindungsart mit der zweiten metallischen Schicht 24 des Substrats 2 verbunden.

Die Verbindung zwischen dem zweiten Anpasselement 52 und einer Grundplatte 40 des Leistungshalbleitermoduls erfolgt mittels einer ersten Verbindungsart. Im hier dargestellten Fall ist es wiederum eine Sinterverbindung, für die bezüglich ihrer Oberflächen oben gesagtes ebenfalls gilt.

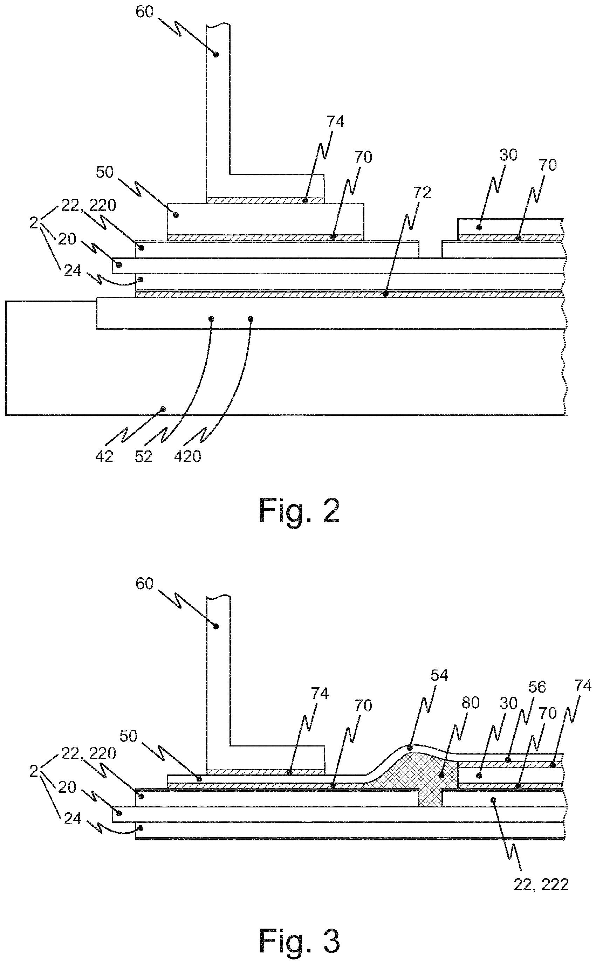

Figur 2 zeigt einen Ausschnitt einer zweiten Ausführungsform eines erfindungsgemäßen Leistungshalbleitermoduls in Seitenansicht. Dargestellt ist neben dem Substrat 2, dem ersten Anpasselement 50 und dem Anschlusselement 60, die allesamt gemäß Fig. 1 ausgebildet sind, eine weitere Leiterbahn 222 auf der ein Leistungshalbleiterbauelement 30 angeordnet ist. Dieses Leistungshalbleiterbauelement 30 ist ebenfalls mittels einer zweiten Verbindungsart, hier einer Sinterverbindung mit der zugeordneten Leiterbahn 222 elektrisch leitend verbunden. Die Verbindungen des ersten Anpasselements 50 sind in dieser Ausführung ebenfalls beide als Sinterverbindungen ausgebildet. Dies bedeutet allerdings keine Einschränkung der oben genannten Allgemeinheit, was insbesondere eine Schweißverbindung zwischen dem Anschlusselement 60 und dem ersten Anpasselement 50 gestattet.

Weiterhin dargestellt ist eine Kühleinrichtung 42 mit integriertem zweiten Anpasselement 52 aus Kupfer. Diese integrierte Kühleinrichtung 42 weist einen Aluminiumkörper auf, der zur Luft- oder Flüssigkeitskühlung ausgebildet ist, wobei das zweite Anpasselement 52 in einer Ausnehmung 420 des Aluminiumkörpers angeordnet ist und mit diesem mittels eines Walzplattierverfahrens stoffschlüssig verbunden ist.

Die Verbindung zwischen dem zweiten Anpasselement 52 und der zweiten metallischen Schicht 24 ist mittels einer zweiten Verbindungsart, hier wiederum einem Sinterverfahren, ausgebildet.

Es ist hierbei besonders vorteilhaft, das zweite Anpasselement 52 in seiner lateralen Ausdehnung, also parallel zu seinen Hauptflächen 520, 522, größer auszubilden als die zweite metallische Schicht 24. Dies erleichtert einerseits die Montage und verbessert andererseits die Wärmespreizung durch das zweite Anpasselement 52.

Figur 3 zeigt einen Ausschnitt einer dritten Ausführungsform eines erfindungsgemäßen Leistungshalbleitermoduls in Seitenansicht. Diese Darstellung weist ohne Beschränkung der Allgemeinheit keine Grundplatte oder Kühleinrichtung auf.

Gegenüber den oben dargestellten Ausführungsformen weist das erste Anpasselement 50 hier einen anderen Werkstoff, eine geringere Dicke und eine wesentlich größere laterale Ausdehnung auf. Das erste Anpasselement 50 ist hier aus Molybdän ausgebildet, während die Werkstoffe des Substrats 2 und des Anschlusselements 60 den oben genannten entsprechen. Durch diese Ausbildung aus Molybdän ist es besonders einfach die Dicke auf einen Wert zu reduzieren, der hier geringfügig unterhalb der Dicke der Leiterbahnen 220, 222 liegt.

Somit kann das erste Anpasselement 50 gleichzeitig auch als interne Verbindungseinrichtung zwischen dem Anschlusselement 60 und einer dem Substrat 2 abgewandten Kontaktfläche 300 des Leistungshalbleiterbauelements 30 wirken. Hierzu weist das erste Anpasselement 50 zwei Abschnitte 54, 56 auf, die nicht mit der ersten Leiterbahn 220 verbunden sind. Der erste Abschnitt 54 ist vorteilhafterweise bogenförmig ausgebildet und geht in den zweiten Abschnitt 56 über der elektrisch leitend mit der Kontaktfläche 300 des Leistungshalbleiterbauelements 30 verbunden ist. Hier ist zur elektrischen Isolation unterhalb des bogenförmigen ersten Abschnitts ein, insbesondere gelartiger, flexibler Isolationsstoff 80 angeordnet.

Jegliche stoffschlüssigen Verbindungen 70, 72, 74 dieser Ausgestaltung sind ohne Beschränkung der oben genannten Allgemeinheit hier als Sinterverbindungen ausgebildet, wobei in bevorzugter Weise alle korrespondierenden Kontaktflächen eine Edelmetalloberfläche aufweisen.

Figur 4 zeigt einen Ausschnitt einer vierten Ausführungsform eines erfindungsgemäßen Leistungshalbleitermoduls in Draufsicht. Dargestellt ist hier der Isolierstoffkörper 20 mit zwei Leiterbahnen 220, 222. Auf einer Leiterbahn 220 sind sowohl zwei erste Anpasselemente 50 wie auch ein Leistungshalbleiterbauelement 30 dargestellt. Ein erstes Anpasselement 50 ist in unmittelbarer Nähe des Eckbereichs 232 der Leiterbahn 220 und ein weiteres in unmittelbarer Nähe des Randbereichs 230 der Leiterbahn 220 angeordnet. Dies ist häufig notwendig, da auf übrigen Bereichen der Leiterbahn Leistungshalbleiterbauelemente und interne Verbindungseinrichtungen, beispielhaft Drahtbondverbindungen, angeordnet sind. Gerade in diesen Fällen in denen Rand- 230 oder gar Eckbereiche 232 dem externen Anschluss dienen ist es notwendig dort ein Ablösen der Leiterbahn 220 vom Isolierstoffkörper 20 zu verhindern.

Die ersten Anpasselemente 50 weisen hier eine jeweilige laterale Ausdehnung 50a, 50b auf die geringer ist als das Eineinhalbfache der korrespondierenden lateralen Ausdehnung 60a, 60b der damit verbunden Anschlusselemente 60.

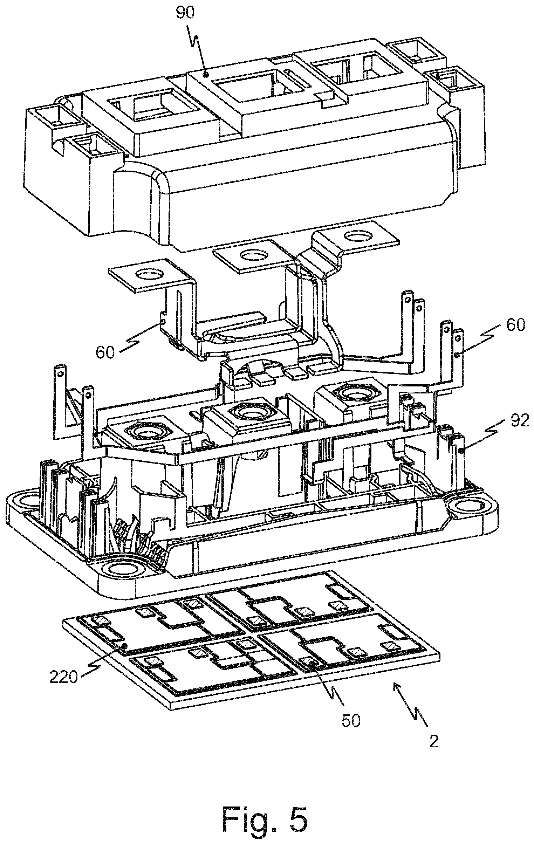

Figur 5 zeigt ein erfindungsgemäßes Leistungshalbleitermodul in dreidimensionaler Explosionsdarstellung. Zu den aus den vorhergehenden Figuren bekannten Komponenten ist hier noch ein zweiteiliges Gehäuse 90, 92 dargestellt. Die Anschlusselemente 60 sind hier als Last- und Hilfsanschlusselemente ausgebildet. Besonders deutlich erkennbar sind hier diejenigen Teile der Anschlusselemente 60, die auf den ersten Anpasselementen 50 zu liegen kommen und mit diesen mittels eines Schweißverfahrens verbunden sind.

**Patentansprüche**

1. Leistungshalbleitermodul mit einem Substrat (2) zur Anordnung auf einer Kühleinrichtung (42) oder einer Grundplatte (40), wobei dieses Substrat (2) eine Isolierstoffkörper (20) und eine auf dessen, dem Inneren des Leistungshalbleitermoduls zugewandten ersten Hauptfläche angeordneten ersten in sich strukturierte und somit erste Leiterbahnen (220, 222) ausbildende metallische Schicht (22) und eine auf dessen zweiter, dem Inneren des Leistungshalbleitermoduls abgewandten Hauptfläche angeordneten zweiten metallischen Schicht (24) aufweist, wobei auf einer Leiterbahn (220, 220) ein Leistungshalbleiterbauelement (30) angeordnet und elektrisch leitend damit verbunden ist und wobei auf dieser oder einer weiteren Leiterbahn (220, 222) ein erstes Anpasselement (50) und hierauf ein Anschlusselement (60) angeordnet ist, wobei eine erste dem ersten Anschlusselement (60) zugewandte Hauptfläche (500) des Anpasselements (50) stoffschlüssig und elektrisch leitend hiermit verbunden ist, wodurch eine erste Verbindungsart ausgebildet wird, während eine zweite der zugeordneten Leiterbahn (220, 222) zugewandte Hauptfläche (502) des ersten Anpasselements (50) mittels eines Verbindungsmittels (70) elektrisch leitend und stoffschlüssig hiermit verbunden ist, wodurch eine zweite Verbindungsart ausgebildet wird, wobei das Leistungshalbleiterbauelement (30) mittels einer Drucksinterverbindung angeordnet und elektrisch leitend verbunden ist und entweder

das erste Anpasselement (50) selbst als interne Verbindungseinrichtung zwischen dem Anschlusselement (60) und einer ersten dem Substrat (2) abgewandten Kontaktfläche (300) des Leistungshalbleiterbauelements (30) ausgebildet ist, wobei die erste Verbindungsart als Schweißverbindung ausgebildet ist und die zweite Verbindungsart als Drucksinterverbindung ausgebildet ist,

oder

zusätzlich zu dem ersten Anpasselement (50), wobei dessen erste Verbindungsart als Schweißverbindung ausgebildet ist und dessen zweite Verbindungsart als Drucksinterverbindung ausgebildet ist, ein zweites Anpasselement (52) zu der Kühleinrichtung (42) oder der Grundplatte (40) angeordnet ist, wobei eine zweite der Kühleinrichtung (42) oder der Grundplatte (40) zugewandte Hauptfläche (522) des Anpasselements (52) hiermit mittels einer Walzplattierverbindung stoffschlüssig verbunden ist.

**2.** Leistungshalbleitermodul nach Anspruch 1, wobei eine erste der zweiten metallischen Schicht (24) zugewandte Hauptfläche (520) des zweiten Anpasselements (52) mittels eines Verbindungsmittels (72) stoffschlüssig durch ein zweites Verbindungsverfahren hiermit verbunden ist.

**3.** Leistungshalbleitermodul nach Anspruch 2, wobei die zweite Verbindungsart als Verbindung mit einem Verbindungsmittel, als Löt- oder Drucksinterverbindung, ausgebildet ist.

**4.** Leistungshalbleitermodul nach Anspruch 1, wobei das erste Anpasselement (50) einen Wärmeausdehnungskoeffizienten aufweist der um plus/minus maximal 30% des Unterschiedes der Wärmeausdehnungskoeffizienten des Substrats (2) und des Anschlusselements (60) um den Mittelwert dieser Wärmeausdehnungskoeffizienten abweicht.

**5.** Leistungshalbleitermodul nach Anspruch 1 oder 2, wobei
das zweite Anpasselement (52) einen Wärmeausdehnungskoeffizienten aufweist der um plus/minus maximal 30% des Unterschiedes der Wärmeausdehnungskoeffizienten des Substrats (2) und der Kühleinrichtung (42) bzw. der Grundplatte (40) um den Mittelwert dieser Wärmeausdehnungskoeffizienten abweicht.

**6.** Leistungshalbleitermodul nach Anspruch 1 oder 2, wobei
das jeweilige Anpasselement (50, 52) eine Dicke aufweist, die mindestens das Dreifache der Dicke der zugeordneten metallischen Schicht (22, 24) des Substrats (2) aufweist.

**7.** Leistungshalbleitermodul nach Anspruch 1, wobei das erste Anpasselement (50) eine jeweilige laterale Ausdehnung (50a, 50b) aufweist, die maximal das Eineinhalbfache der lateralen Ausdehnung (60a, 60b) der zugeordneten Kontaktfläche des Anschlusselements (60) beträgt.

**8.** Leistungshalbleitermodul nach Anspruch 7, wobei das erste Anpasselement in unmittelbarer Nähe zu einem Randbereich oder einem Eckbereich einer zugeordneten Leiterbahn angeordnet ist.

**9.** Leistungshalbleitermodul nach Anspruch 1 oder 2, wobei
das zweite Anpasselement (52) eine laterale Ausdehnung aufweist, die größer ist als die Ausdehnung der zugeordneten zweiten metallischen Schicht (24) des Substrats (2).

**Claims**

**1.** Power semiconductor module with a substrate (2) for arranging on a cooling device (42) or on a base plate (40), wherein said substrate (2) has an insulator (20) and a first metallic layer (22) which is arranged on its first main surface facing the interior of the power semiconductor module, is textured per se and therefore forms first strip conductors (220, 222) and a second metallic layer (24) which is arranged on its second main surface facing away from the interior of the power semiconductor module, wherein a power semiconductor component (30) is arranged on a strip conductor (220, 220) and is connected thereto in an electrically conducting manner, and wherein a first adaptation element (50) is arranged on said strip conductor or a further strip conductor (220, 222) and a connection element (60) is arranged on said adaptation element, wherein a first main surface (500) of the adaptation element (50), which main surface faces the first connection element (60), is connected to said adaptation element in an integrally bonded and electrically conducting manner, thus forming a first type of connection, while a second main surface (502) of the first adaptation element (50), which main surface faces the associated strip conductor (220, 222), is connected to said adaptation element by means of a connecting means (70) in an electrically conducting and integrally bonded manner, thus forming a second type of connection, wherein the power semiconductor component (30) is arranged and connected in an electrically conducting manner by means of a pressure-sintering connection and either the first adaptation element (50) itself is in the form of an internal connecting device between the connection element (60) and a first contact surface (300) of the power semiconductor component (30), which contact surface faces away from the substrate (2), wherein the first type of connection is in the form of a welding connection and the second type of connection is in the form of a pressure-sintering connection,

or in addition to the first adaptation element (50), wherein the first type of connection thereof is in the form of a welding connection and the second type of connection thereof is in the form of a pressure-sintering connection, a second adaptation element (52) is arranged with respect to the cooling device (42) or to the base plate (40), wherein a second main surface (522) of the adaptation element (52), which main surface faces the cooling device (42) or the base plate (40), is connected to said adaptation element (52) in an integrally bonded manner by means of a roll-cladding connection.

2. Power semiconductor module according to Claim 1, wherein a first main surface (520) of the second adaptation element (52), which main surface faces the second metallic layer (24), is connected to said adaptation element by means of a connecting means (72) in an integrally bonded manner by a second connecting method.

3. Power semiconductor module according to Claim 2, wherein the second type of connection is in the form of a connection with a connecting means, in the form of a soldered or pressure-sintering connection.

4. Power semiconductor module according to Claim 1, wherein the first adaptation element (50) has a coefficient of thermal expansion which deviates by plus/minus at maximum 30% of the difference between the coefficients of thermal expansion of the substrate (2) and of the connection element (60) from the average value of said coefficients of thermal expansion.

5. Power semiconductor module according to Claim 1 or 2, wherein the second adaptation element (52) has a coefficient of thermal expansion which deviates by plus/minus at maximum 30% of the difference between the coefficients of thermal expansion of the substrate (2) and of the cooling device (42) or of the base plate (40) from the average value of said coefficients of thermal expansion.

6. Power semiconductor module according to Claim 1 or 2, wherein each adaptation element (50, 52) has a thickness which is at least three times the thickness of the associated metallic layer (22, 24) of the substrate (2).

7. Power semiconductor module according to Claim 1, wherein the first adaptation element (50) has a respective lateral extent (50a, 50b) which is at maximum one and a half times the lateral extent (60a, 60b) of the associated contact surface of the connection element (60).

8. Power semiconductor module according to Claim 7, wherein the first adaptation element is arranged in the direct vicinity of an edge region or a corner region of an associated strip conductor.

9. Power semiconductor module according to Claim 1 or 2, wherein the second adaptation element (52) has a lateral extent which is greater than the extent of the associated second metallic layer (24) of the substrate (2).

**Revendications**

1. Module semi-conducteur de puissance comprenant un substrat (2) destiné à être disposé sur un dispositif de refroidissement (42) ou une plaque de base (40), dans lequel ledit substrat (2) comporte un corps isolant (20) et, sur sa surface principale qui est tournée vers l'intérieur du module semi-conducteur de puissance, une première couche métallique (22) structurée en elle-même et formant ainsi des premières pistes conductrices (220, 222) et, sur sa seconde surface principale disposée de manière tournée à l'opposé de l'intérieur du module semi-conducteur de puissance, une seconde couche métallique (24), dans lequel un dispositif semi-conducteur de puissance (30) est disposé sur une piste conductrice (220, 220) et est électriquement relié à cette dernière, et dans lequel un premier élément d'adaptation (50) est disposé sur cette piste conductrice ou une autre piste conductrice (220, 222) et un élément de connexion (60) est disposé sur cette dernière, dans lequel une première surface principale (500) de l'élément d'adaptation (50) qui est tournée vers le premier élément de connexion (60) est reliée à ce dernier de manière électriquement conductrice par complémentarité de matériau, un premier type de connexion étant ainsi formé, tandis qu'une seconde surface principale (502) du premier élément d'adaptation (50) qui est tournée vers la piste conductrice associée (220, 222) est reliée de manière électriquement conductrice par complémentarité de matériau à ce dernier au moyen d'un moyen de connexion (70), un second type de connexion étant ainsi formé, dans lequel le dispositif semi-conducteur de puissance (30) est disposé au moyen d'une liaison frittée sous pression et est relié de manière électriquement conductrice, et soit le premier élément d'adaptation (50) est lui-même formé en tant que dispositif de liaison interne entre l'élément de connexion (60) et une première surface de contact (300) du dispositif semi-conducteur de puissance (30) qui est tournée à l'opposé du substrat (2), dans lequel le premier type de liaison est réalisé sous la forme d'une liaison soudée et le second type de liaison est réalisé sous la forme d'une liaison frittée sous pression, soit

en complément du premier élément d'adaptation (50), dans lequel son premier type de liaison est réalisé sous la forme d'une liaison soudée et son second type de liaison est réalisé sous la forme d'une liaison frittée sous pression, un second élément d'adaptation (52) est disposé sur le dispositif de refroidissement (42) ou la plaque de base (40), dans lequel une seconde surface principale (522) de l'élément d'adaptation (52) qui est tournée vers le dispositif de refroidissement (42) ou la plaque de base (40) est reliée à ce dernier par complémentarité de matériau au moyen d'une liaison par laminage.

2. Module semi-conducteur de puissance selon la revendication 1, dans lequel
une première surface principale (520) du second élément d'adaptation (52) qui est tournée vers la seconde couche métallique (24) est reliée à cette dernière par un moyen de liaison (72) au moyen d'un second procédé de liaison.

3. Module semi-conducteur de puissance selon la revendication 2, dans lequel
le second type de liaison est réalisé sous la forme d'une liaison à un moyen de liaison, ou sous la forme d'une liaison soudée ou frittée sous pression.

4. Module semi-conducteur de puissance selon la revendication 1, dans lequel
le premier élément d'adaptation (50) présente un coefficient de dilatation thermique qui diffère au plus de plus ou moins 30 % de la différence entre les coefficients de dilatation thermique du substrat (2) et de l'élément de liaison (60) par rapport à la valeur moyenne desdits coefficients de dilatation thermique.

5. Module semi-conducteur de puissance selon la revendication 1 ou 2, dans lequel
le second élément d'adaptation (52) présente un coefficient de dilatation thermique qui diffère au plus de plus ou moins 30 % de la différence entre les coefficients de dilatation thermique du substrat (2) et du dispositif de refroidissement (42) ou de la plaque de base (40) par rapport à la valeur moyenne desdits coefficients de dilatation thermique.

6. Module semi-conducteur de puissance selon la revendication 1 ou 2, dans lequel
l'élément d'adaptation respectif (50, 52) présente une épaisseur au moins trois fois supérieure à l'épaisseur de la couche métallique associée (22, 24) du substrat (2).

7. Module semi-conducteur de puissance selon la revendication 1, dans lequel
le premier élément d'adaptation (50) présente une extension latérale respective (50a, 50b) au plus une fois et demie supérieure à l'extension latérale (60a, 60b) de la surface de contact associée de l'élément de connexion (60).

8. Module semi-conducteur de puissance selon la revendication 7, dans lequel le premier élément d'adaptation est situé à proximité immédiate d'une région de bord ou d'angle d'une piste conductrice associée.

9. Module semi-conducteur de puissance selon la revendication 1 ou 2, dans lequel le second élément d'adaptation (52) présente une extension latérale supérieure à l'extension de la seconde couche métallique associée (24) du substrat (2).

Fig. 1

Fig. 2

Fig. 3

Fig. 4

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102009037257 A1
- EP 0706221 A